# EUROPÄISCHE PATENTSCHRIFT

(11) **EP 1 099 014 B1**
(45) Veröffentlichungstag und Bekanntmachung des Hinweises auf die Patenterteilung: **27.03.2002**
(21) Anmeldenummer: 99942775.0
(22) Anmeldetag: 05.07.1999
(51) Int. Cl.: C30B 23/00, C30B 29/36

(54) **VORRICHTUNG UND VERFAHREN ZUR HERSTELLUNG MINDESTENS EINES SiC-EINKRISTALLS**
METHOD AND DEVICE FOR PRODUCING AT LEAST ONE SILICON CARBIDE MONOCRYSTAL
DISPOSITIF ET PROCEDE POUR LA PRODUCTION D'AU MOINS UN MONOCRISTAL DE SiC

(30) Priorität: 14.07.1998 DE 19831556
(43) Veröffentlichungstag der Anmeldung: 16.05.2001
(73) Patentinhaber: SIEMENS AKTIENGESELLSCHAFT, 80333 München (DE)
(72) Erfinder: STEIN, Rene, D-91341 Röttenbach (DE); VÖLKL, Johannes, D-91056 Erlangen (DE); KUHN, Harald, D-91056 Erlangen (DE); RUPP, Roland, D-91207 Lauf (DE)
(86) Internationale Anmeldenummer: DE9902066
(87) Internationale Veröffentlichungsnummer: WO0004212

(56) Entgegenhaltungen:
- WO-A-94/23096
- DE-A- 4 310 745
- US-A- 5 667 587
- US-A- 5 683 507

## Beschreibung

Die Erfindung betrifft eine Vorrichtung und ein Verfahren zur Herstellung mindestens eines Siliciumcarbid(SiC)-Einkristalls gemäß dem Oberbegriff des Anspruchs 1 bzw. des Anspruchs 12. Eine derartige Vorrichtung und ein derartiges Verfahren sind beispielsweise aus der *WO 94/23096 A1* bekannt.

Mit der WO 94/23096 A1 wird eine Vorrichtung und ein Verfahren zur Herstellung eines SiC-Einkristalls offenbart, die sich der Sublimation von SiC in fester Form, beispielsweise von technischem SiC in Pulverform, sowie der Abscheidung des durch die Sublimation entstehenden SiC's in der Gasphase auf einem einkristallinen SiC-Keimkristall bedienen. Dabei kommt ein Reaktionsgefäß in Tiegelform zum Einsatz, das einen Vorratsbereich und einen Reaktionsbereich beinhaltet, die durch einen Gaskanal miteinander verbunden sind. Alternativ kann zwischen dem Vorratsbereich und dem Reaktionsbereich ein zusätzlicher Homogenisierungsbereich zwischengeschaltet werden, der ebenfalls über jeweils einem Gaskanal mit dem Vorratsbereich und dem Reaktionsbereich in Verbindung steht. In dem Vorratsbereich befindet sich das feste SiC, in dem Reaktionsbereich ist dagegen der einkristalline SiC-Keimkristall angeordnet, auf dem der SiC-Einkristall aufwächst. In der genannten Schrift werden auch Ausführungsformen angegeben, in denen mehrere SiC-Einkristalle auf jeweils zugehörigen SiC-Keimkristallen abgeschieden werden. Dabei sind Ausführungsvarianten mit einem, aber auch mit mehreren Vorratsbereichen offenbart. Außerhalb des Reaktionsgefäßes befindet sich eine Heizeinrichtung, die insbesondere auch mehrteilig entsprechend der Einteilung des Reaktionsgefäßes in den Vorrats- und Reaktionsbereich aufgebaut sein kann. Durch diese Heizeinrichtung wird der in dem Vorratsbereich befindliche Vorrat an festem SiC auf eine Temperatur von 2000 C bis 2500°C erhitzt. Dadurch wird das feste SiC sublimiert. Das dabei entstehende Gasgemisch besteht hauptsächlich aus den Komponenten Si (Silicium), Si₂C, SiC₂ und SiC. Dieses Gasgemisch wird im folgenden auch mit "SiC in der Gasphase" bezeichnet.

Durch Einstellen eines Temperaturgradienten zwischen dem Vorrat an festem SiC und dem SiC-Keimkristall, bzw. dem bereits aufgewachsenen SiC-Einkristall, wird das sublimierte Gasgemisch von dem Vorratsbereich in den Reaktionsbereich, insbesondere zu dem SiC-Keimkristall, transportiert. Der Strom des SiC's in der Gasphase wird dabei durch die Geometrie des Gaskanals in seiner Transportrate und auch seiner Richtung eingestellt.

Die einzelnen Bestandteile des Reaktionsgefäßes bestehen vorzugsweise aus hochreinem Elektrographit. Dabei handelt es sich um isostatisch gepreßten Graphit. Solche Graphitarten sind in verschiedenen Dichten kommerziell verfügbar. Sie unterscheiden sich durch ihr spezifisches Gewicht und durch eine unterschiedliche Porosität. Selbst höchstverpreßte Graphite weisen noch ein Porenvolumen von wenigstens 8 bis 12 % auf. Diese Restporosität ist für die Siliciumcarbid-Züchtung von Bedeutung. Denn die bei der Siliciumcarbid-Züchtung vorhandenen Gase, speziell die siliciumhaltigen Gase, dringen in die Poren ein und reagieren dort mit dem Graphit.

In dem Aufsatz *"Formation of Macrodefects in SiC", R.A.Stein, Physica B, Vol. 185, 1993, Seiten 211 bis 216* wird außerdem ein Phänomen beschrieben, das die Reaktion von festem SiC mit dem Kohlenstoff in dem als Gefäßmaterial verwendeten Graphit betrifft. Demgemäß bilden kleine Poren bzw. Versetzungen im Bereich einer Grenzfläche zwischen einem Untergrundmaterial aus Graphit und einem darauf angebrachten SiC-Keimkristall den Ausgangspunkt zunächst für die Entstehung und dann auch das sich anschließende Wachstum von Hohlräumen im SiC-Keimkristall. Unter den in dem Reaktionsgefäß herrschenden Bedingungen breiten sich diese Hohlräume über den Keimkristall hinaus auch in dem herzustellenden SiC-Einkristall aus. Diese Hohlräume führen zu einer verminderten Qualität des hergestellten SiC-Einkristalls.

Wie aus der WO 94/23096 A1 bekannt ist, findet ein Materialtransport von dem Vorrat aus festem SiC zu dem SiC-Keimkristall über die Einstellung eines Temperaturgradienten und eines sich infolge ausbildenden Wärmeflusses statt. Bei der Steuerung von Wärmeflüssen im Tiegel über konstruktive Maßnahmen, die Teile oder Einsätze aus Graphit vorsehen, treten wieder die oben bereits erwähnten Schwierigkeiten aufgrund der Reaktion des SiC's in der Gasphase mit dem Graphit auf.

Mit der *SU 882247 A1* wird Tantal als geeignetes Material für den Tiegel oder zumindest für einen Einsatz innerhalb des Tiegels offenbart. Jedoch auch Tantal geht eine Reaktion mit dem SiC in der Gasphase ein. Insbesondere kommt es zu einer Carbidisierung, wobei sich die Dimensionen der aus Tantal bestehenden Vorrichtung ändern. Wenn z.B. Tantaldicken von mehreren Millimetern vorgesehen werden, kann dies zu mechanischen Spannungen in dem Tiegel führen.

Mit der *US 5,667,587* wird ein Tiegel für eine Sublimations-Züchtung eines SiC-Einkristalls offenbart, dessen Innenwände mit einem thermisch anisotropen Belag beschichtet sind. Insbesondere besteht diese Beschichtung aus Pyrographit. Die thermische Anisotropie des Pyrographits dient hierbei der oben angesprochenen Steuerung von Wärmeflüssen innerhalb des Tiegels. Da die Beschichtung jedoch genau wie der mit der WO 94/23096 A1 offenbarte Gaskanal aus einem Graphitmaterial besteht, treten auch hier die unerwünschten Reaktionen mit dem SiC in der Gasphase auf. Hierbei ist es unerheblich, ob Elektro- oder Pyrographit verwendet wird.

Es ist nun die Aufgabe der Erfindung, eine Vorrichtung sowie ein Verfahren der eingangs bezeichneten Art anzugeben, die eine Steuerung von Wärmeflüssen im Tiegel ermöglichen und die zugleich die unerwünschten Reaktionen der beim Stand der Technik verwendeten Materialien mit festem SiC oder auch mit SiC in der Gasphase vermeiden.

Zur Lösung der die Vorrichtung betreffende Teilaufgabe wird eine Vorrichtung entsprechend den kennzeichnenden Merkmalen des unabhängigen Patentanspruchs 1 angegeben.

Bei der erfindungsgemäßen Vorrichtung zur Herstellung mindestens eines Siliciumcarbid-Einkristalls handelt es sich um eine Vorrichtung, welche
a) einen Tiegel mit
   a1) mindestens einem Vorratsbereich zur Aufnahme eines Vorrats aus festem SiC und mit
   a2) mindestens einem Kristallbereich zur Aufnahme jeweils eines SiC-Keimkristalls, auf dem der SiC-Einkristall aufwächst, sowie
b) eine außerhalb des Tiegels angeordnete Heizeinrichtung umfaßt, wobei
c) in dem Tiegel mindestens ein Einsatz aus Glaskohle angeordnet ist.

Zur Lösung der das Verfahren betreffenden Teilaufgabe wird ein Verfahren entsprechend dem kennzeichnenden Merkmal des unabhängigen Patentanspruchs 13 angegeben.

Bei dem erfindungsgemäßen Verfahren zur Herstellung mindestens eines Siliciumcarbid-Einkristalls handelt es sich um ein Verfahren, bei welchem
a) ein Vorrat aus festem SiC in mindestens einen Vorratsbereich eines Tiegels eingebracht wird,
b) mindestens ein SiC-Keimkristall in den Tiegel eingebracht wird,
c) durch eine Erhitzung des Vorrats das feste SiC sublimiert und SiC in der Gasphase erzeugt wird,
d) das SiC in der Gasphase zu dem mindestens einen SiC-Keimkristall transportiert wird und dort als der mindestens eine SiC-Einkristall aufwächst, und
e) mindestens ein Wärmefluß über mindestens einen in dem Tiegel vorgesehenen Einsatz aus Glaskohle gesteuert wird.

Die Erfindung beruht dabei auf der Erkenntnis, daß sich Glaskohle aufgrund seiner hervorragenden Eigenschaften sehr gut für einen Einsatz in einem Tiegel, der zur Herstellung von SiC-Einkristallen verwendet wird, eignet. Glaskohle ist ein amorpher, isotroper Werkstoff, der einen erheblich über der bei der Herstellung von SiC-Einkristallen üblichen Temperatur von bis zu 2500°C liegenden Schmelzpunkt aufweist. Da Glaskohle außerdem eine höhere Dichte und mit einem Porenvolumen von praktisch 0 % eine wesentlich niedrigere Porosität als alle Graphitarten aufweist, zeigt die Glaskohle auch eine verglichen mit Graphit deutlich verringerte Reaktionsneigung sowohl mit festem SiC als auch mit SiC in der Gasphase. Außerdem liegt die thermische Leitfähigkeit von Glaskohle um etwa den Faktor 10 niedriger als bei Graphit. Damit ist Glaskohle ein besserer thermischer Isolator als Graphit. Dies bedeutet, daß Wärmeflüsse im Tiegel durch Einsätze aus Glaskohle in bestimmte Richtungen gelenkt werden können.

Glaskohle erfüllt somit aufgrund seiner hohen thermischen Isolationsfähigkeit die Erfordernisse für eine Steuerung von Wärmeflüssen innerhalb des Tiegels. Darüber hinaus ist auch die Reaktionsneigung von Glaskohle mit SiC aufgrund der hohen Dichte deutlich niedriger als bei anderen gemäß dem Stand der Technik verwendeten Materialien, wie z.B. den Graphitarten.

Besondere Ausgestaltungen und Weiterbildungen der Vorrichtung und des Verfahrens nach der Erfindung ergeben sich aus den jeweils abhängigen Unteransprüchen.

Eine erste bevorzugte Ausgestaltung sieht eine spezielle Steuerung bzw. Führung eines ersten Wärmeflusses vor. Dieser erste Wärmefluß hat zur Folge, daß das SiC in der Gasphase gezielt auf eine Kristallisationsfront am SiC-Keimkristall oder am bereits aufgewachsenen SiC-Einkristall geleitet wird. Der erste Wärmefluß wird nun insbesondere so gesteuert, daß er mindestens am Ort der Kristallisationsfront, d.h. an der Stelle, an der aktuell das Kristallwachstum auf dem SiC-Keimkristall oder dem bereits aufgewachsenen SiC-Einkristall stattfindet, über seinen kompletten Querschnitt eine einheitliche Orientierung (=parallele Flußvektoren) aufweist. Bevorzugt wird diese Eigenschaft des ersten Wärmeflusses auch schon innerhalb einer der Kristallisationsfront vorgelagerten Zone eingestellt. Dadurch werden an der Kristallisationsfront selbst sowohl eine einheitliche Temperatur (=Isotherm-Ebene) als auch eine einheitliche Konzentration des SiC's in der Gasphase (= Ebene gleicher Materialkonzentration) eingestellt. Dies wirkt sich im Hinblick auf ein homogenes und fehlerfreies Kristallwachstum günstig aus.

In einer weiteren vorteilhaften Ausführungsform befindet sich ein hohlzylindrischer Gaskanal aus Glaskohle im Inneren des Tiegels. An einem dem Vorratsbereich abgewandten Ende dieses Gaskanals ist der SiC-Keimkristall, auf dem der SiC-Einkristall aufwächst, plaziert. Aus dem Vorrat sublimiertes SiC in der Gasphase bewegt sich aufgrund eines eingestellten Temperaturgradienten auf ein dem Vorratsbereich zugewandtes Ende des Gaskanals zu. Durch den Gaskanal bildet sich ein erster Wärmefluß, der zur Folge hat, daß das SiC in der Gasphase gezielt auf die Kristallisationsfront am SiC-Keimkristall oder am bereits aufgewachsenen SiC-Einkristall geleitet wird. Aufgrund des guten thermischen Isolationsvermögens der für den Gaskanal verwendeten Glaskohle erfolgt die Bündelung des ersten Wärmeflusses und damit auch der Transport des SiC's in der Gasphase besonders effektiv. Es kommt nur zu geringen Wärmeverlusten durch Wände des Gaskanals.

Vorteilhaft ist eine Ausführungsform, bei der eine Hauptrichtung des ersten Wärmeflusses nahezu parallel zu einer ersten, dem SiC-Einkristall zugeordneten Mittenachse verläuft. Dadurch ergibt sich am aufwachsenden SiC-Einkristall eine besonders günstige ebene oder leicht konvexe Wachstumsphasengrenze. Solange die Hauptrichtung des ersten Wärmeflusses und die erste, dem SiC-Einkristall zugeordnete Mittenachse einen Winkel von weniger als 10° einschließen, wird in diesem Zusammenhang von einer nahezu parallelen Ausrichtung ausgegangen. Da der erste Wärmefluß maßgeblich durch den Gaskanal gesteuert wird, weist seine Hauptrichtung praktisch die gleiche Orientierung auf wie eine zweite, dem Gaskanal zugeordnete Mittenachse.

In einer anderen bevorzugten Ausbildung der Vorrichtung wird die Steuerung des ersten Wärmeflusses weiter verbessert, indem eine längs der zweiten Mittenachse verlaufende Wand des Gaskanals nicht mit konstanter Wanddicke ausgeführt wird. Durch eine entsprechende Variation der Wanddicke entlang der zweiten Mittenachse werden die angesprochenen Verbesserungen erzielt. Insbesondere gelingt dies, wenn die Wanddicke ausgehend von dem SiC-Keimkristall in Richtung des Vorratsbereichs stetig zunimmt.

Bevorzugte Dicken für die Wand des Gaskanals liegen zwischen 0,1 und 5 mm. Glaskohle kann in diesen Stärken problemlos gefertigt werden.

Neben den besprochenen Ausführungsformen mit einer Steuerung eines ersten Wärmeflusses innerhalb des Tiegels lassen sich auch Ausführungsformen angeben, bei denen Wärmeflüsse zwischen dem Innen- und Außenraum des Tiegels durch die Verwendung eines Einsatzes aus Glaskohle gesteuert werden.

Eine vorteilhafte Ausführungsform ergibt sich, wenn auf einer dem SiC-Einkristall abgewandten Seite des SiC-Keimkristalls eine erste Platte aus Glaskohle angeordnet wird. Diese erste Platte erfüllt hierbei gleichzeitig mehrere Funktionen. Aufgrund einer 3- bis 4fach höheren Biegefestigkeit von Glaskohle verglichen mit Graphit kann die erste Platte wesentlich dünner ausgeführt werden als eine entsprechende Platte aus Graphit. Dadurch ergibt sich eine leichtere Wärmeabfuhr von dem SiC-Keimkristall. Um den Temperaturgradienten zwischen dem Vorrat und dem SiC-Keimkristall aufrechtzuerhalten, ist es notwendig, Wärme am SiC-Keimkristall abzuführen. Dies geschieht über die erste Platte.

Ein bevorzugter Dickenbereich für die erste Platte liegt dabei zwischen 0,1 und 2 mm. Insbesondere bevorzugt wird eine Plattendicke von 0,5 mm.

Eine zweite ganz wesentliche Funktion der ersten Platte aus Glaskohle besteht darin, unerwünschte Reaktionen des SiC-Keimkristalls mit dem Untergrund zu vermeiden. Bei Aufbringen des SiC-Keimkristalls auf einen Untergrund aus Graphit, beispielsweise direkt auf eine erste Tiegelwand an einer oberen Tiegelinnenseite, reagiert das Siliciumcarbid des SiC-Keimkristalls mit dem Kohlenstoffuntergrund. Dadurch kommt es zur Ausbildung von Hohlräumen, die sich auch in dem aufwachsenden SiC-Einkristall fortpflanzen und somit die Qualität des hergestellten SiC-Einkristalls vermindern. Derartige SiC-Einkristalle können nicht mehr für alle Anwendungen eingesetzt werden.

Es wurde nun herausgefunden, daß das Aufbringen des SiC-Keimkristalls auf einen Untergrund aus Glaskohle zu einer erheblich verbesserten Qualität des hergestellten SiC-Einkristalls führt. Die Begründung hierfür liegt in den Materialeigenschaften von Glaskohle. Glaskohle weist eine deutlich verringerte Reaktionsneigung mit dem SiC des SiC-Keimkristalls auf. Da somit keine Hohlräume an der Grenzschicht zwischen dem SiC-Keimkristall und der ersten Platte aus Glaskohle entstehen, wird infolge auch die Dichte der Hohlräume in dem hergestellten SiC-Einkristall erheblich reduziert.

In einer weiteren Ausführungsform wird der Vorwärtsbereich durch eine zweite Platte aus Glaskohle, die sich am Boden des Vorratsbereichs befindet, thermisch isoliert. Insbesondere kann die zweite Platte einfach auf eine zweite Tiegelwand, die den Vorwärtsbereich nach unten begrenzt, gelegt werden. Durch die zweite Platte aus Glaskohle wird somit ein Wärmeverlust in dem Vorratsbereich verhindert. Ein dritter Wärmefluß, der ohne die zweite Platte Wärme aus dem Vorratsbereich und dem Tiegel abführen würde, wird bei dieser vorteilhaften Ausführungsform in den Vorratsbereich zurückgeleitet. Auf diese Weise bleibt die Wärmeenergie im Vorratsbereich erhalten und trägt hier zur Sublimation des SiC's bei.

Bevorzugte Ausführungsbeispiele werden nunmehr anhand der Zeichnung näher erläutert. Zur Verdeutlichung ist die Zeichnung nicht maßstäblich ausgeführt, und gewisse Merkmale sind schematisiert dargestellt. Im einzelnen zeigen:
- Figur 1: eine Vorrichtung zur Herstellung eines SiC-Einkristalls mit einem Gaskanal aus Glaskohle,
- Figur 2: eine weitere Vorrichtung zur Herstellung eines SiC-Einkristalls mit mehreren Einsätzen aus Glaskohle in dem Tiegel und
- Figur 3: einen Tiegel zur Herstellung von zwei SiC-Einkristallen mit mehreren Einsätzen aus Glaskohle.

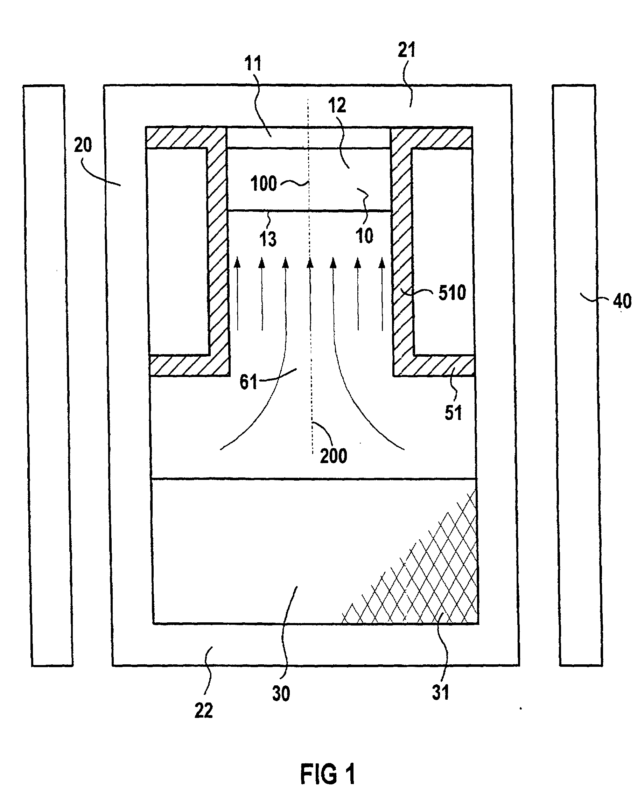

Einander entsprechende Teile sind in den Figuren 1 bis 3 mit denselben Bezugszeichen versehen.

Die in Figur 1 gezeigte Vorrichtung dient zur Herstellung eines SiC-Einkristalls 10 in einem Tiegel 20. Der Tiegel 20 beinhaltet einen Vorratsbereich 30 und einen Kristallbereich 12, die an jeweils gegenüberliegende Tiegelwände angrenzen. Der Kristallbereich 12 grenzt dabei an eine obere erste Tiegelwand 21, der Vorratsbereich 30 an eine untere zweite Tiegelwand 22 an. Der Vorratsbereich 30 ist zur Aufnahme eines Vorrats 31 aus festem Siliciumcarbid insbesondere in Form von pulverförmigem SiC vorgesehen. Im Kristallbereich 12 wird ein SiC-Keimkristall, der aus einkristallinem Siliciumcarbid besteht, an der ersten Tiegelwand 21 angebracht. Eine der ersten Tiegelwand 21 gegenüberliegende Seite des Keimkristalls 11 dient dabei als Wachstumsfläche für den SiC-Einkristall 10.

Mittels einer außerhalb des Tiegels 20 angeordneten Heizeinrichtung 40 wird der Vorrat 31 aus festem SiC, der sich in dem Vorratsbereich 30 befindet, auf eine Temperatur zwischen 2300°C und 2500°C erhitzt. Dadurch wird das feste SiC im Vorrat 31 sublimiert. Die Heizeinrichtung 40 ist im vorliegenden Fall als induktive Heizspule ausgeführt. Eine Widerstandsheizung ist jedoch ebenfalls möglich. Das dann vorliegende SiC in der Gasphase wird aufgrund eines zwischen dem Vorrat 31 und dem SiC-Keimkristall 11 eingestellten Temperaturgradienten zu dem SiC-Einkristall 10 transportiert. Dort wird das SiC in der Gasphase an einer Kristallisationsfront 13 als einkristallines SiC abgeschieden.

Um die Ausbeute bei der Züchtung des SiC-Einkristalls weiter zu erhöhen, ist in dem Tiegel 20 ein hohlzylindrischer Gaskanal 51 angeordnet. Dieser dient einer Bündelung eines von dem Vorrat 31 ausgehenden ersten Wärmeflusses 61 auf den SiC-Keimkristall 11. Mit der Bündelung des erstes Wärmeflusses 61 ist auch eine Konzentration des mitgeführten SiC's in der Gasphase verbunden, so daß ein möglichst großer Anteil des aus dem Vorrat 31 sublimierten SiC's auch tatsächlich zu dem SiC-Keimkristall 11 bzw. dem bereits aufgewachsenen SiC-Einkristall 10 gelangt und dort zum (weiteren) Wachstum des SiC-Einkristalls 10 beitragen kann. Aufgrund der besseren thermischen Isolationsfähigkeit leistet der aus Glaskohle bestehende Gaskanal 51 eine effektivere Führung und Steuerung des Wärmeflusses 61 als ein vergleichbarer Gaskanal aus Graphit. Darüber hinaus bietet die verwendete Glaskohle den Vorteil, weitgehend resistent gegen das SiC in der Gasphase zu sein. Verglichen mit Graphit weist Glaskohle eine deutlich niedrigere Reaktionsneigung sowohl mit festem SiC als auch mit SiC in der Gasphase auf.

Die geringe Reaktionsneigung von festem SiC mit Glaskohle erklärt auch die einfache Kristallentnahme nach abgeschlossener Züchtung. Der aus Glaskohle bestehende Gaskanal 51 umschließt den Kristallbereich 12, in dem das Kristallwachstum des SiC-Einkristalls stattfindet, vollständig. Da aus den obengenannten Gründen eine Reaktion mit einer Wand 510 des Gaskanals unterbleibt und der gezüchtete SiC-Einkristall 10 insbesondere nicht mit der Wand 510 verwächst, ist eine Entnahme des SiC-Einkristalls 10 nach Abschluß des Züchtungsvorgangs problemlos möglich.

Aufgrund der konstruktiven Gegebenheiten des Tiegels 20 ist eine erste Mittenachse 100 des SiC-Einkristalls 10 genau parallel zu einer zweiten Mittenachse 200 des Gaskanals 51 gerichtet. Da die zweite Mittenachse 200 auch mit einer Hauptrichtung des Wärmeflusses 61 zusammenfällt, ist der Wärmefluß 61 somit ebenfalls parallel zu der ersten Mittenachse 100 des SiC-Einkristalls 10 gerichtet. Der Gaskanal 51 bewirkt außerdem, daß der erste Wärmefluß 61 innerhalb einer der Kristallisationsfront 13 vorgelagerten Zone praktisch vollständig parallel verläuft. Dadurch ergibt sich eine ebene oder eine leicht konvexe Kristallisationsfront 13 am SiC-Einkristall 10 und ein besonders günstiges Kristallwachstum.

Durch eine Steuerung des Wärmeflusses 61 entsprechend der Vorrichtung von Figur 1 läßt sich ein weitgehend spannungsfreier SiC-Einkristall 10 züchten, der folglich auch eine sehr geringe Versetzungsdichte aufweist.

In einer nicht dargestellten Ausführungsvariante kann die Glaskohle des Gaskanals 51 zusätzlich mit einem hochschmelzenden Material wie Tantal, Niob, Wolfram, Osmium, Iridium, Rhenium oder mit einem derer Carbide dünn beschichtet sein.

Damit kann das thermische und chemische Verhalten weiter verbessert werden.

Die Dicke der Glaskohle, die für die Wand 510 des Gaskanals 51 verwendet wird, beträgt etwa 0,5 mm.

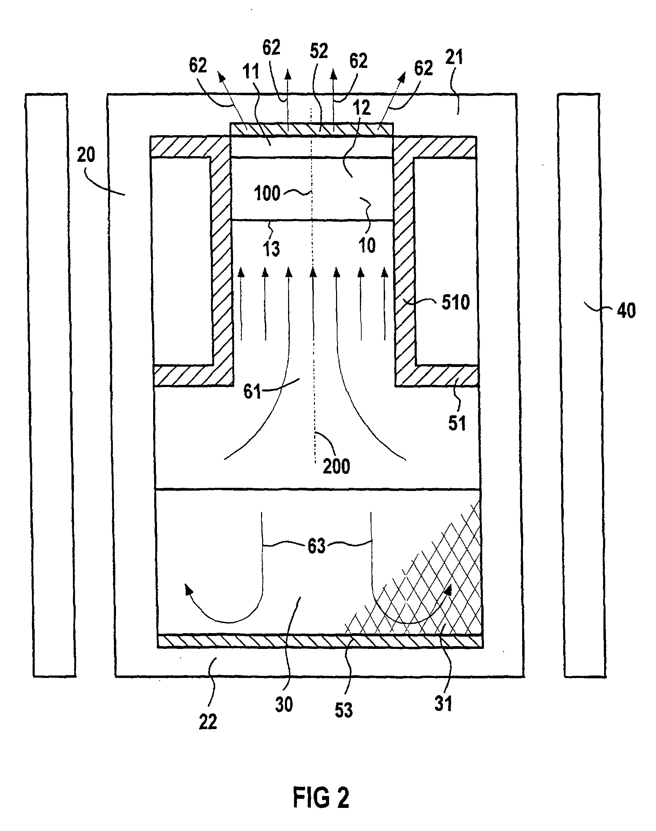

In Figur 2 ist eine weitere Vorrichtung zur Herstellung eines SiC-Einkristalls 10 dargestellt. Im Unterschied zu der Vorrichtung von Figur 1 enthält die Vorrichtung von Figur 2 weitere Einsätze aus Glaskohle. Dies ist zum einen eine erste Platte 52 aus Glaskohle, die sich zwischen dem SiC-Keimkristall 11 und der ersten Tiegelwand 21 befindet. Außerdem wurde am Boden des Vorratsbereichs 30 auf der zweiten Tiegelwand 22 eine zweite Platte 53 ebenfalls aus Glaskohle angeordnet.

Die erste Platte 52 dient dabei sowohl einer Wärmeabfuhr von dem SiC-Keimkristall in einen Außenbereich des Tiegels 20. In dem in Figur 2 dargestellten Ausführungsbeispiel befindet sich die zweite Platte 52 dazu in einer Aussparung in der ersten Tiegelwand 21. Da Glaskohle an und für sich eine gute thermische Isolationsfähigkeit aufweist, ist die Platte 52 nur sehr dünn ausgeführt, um dennoch einen ausreichenden zweiten Wärmefluß 62 in den Außenbereich zu gewährleisten.

Die Dicke der ersten Platte 52 beträgt deshalb nur etwa 0,5 mm.

In einer nicht dargestellten Ausführungsform wird die Wärmeabfuhr weiter erhöht, indem die dem SiC-Keimkristall 11 abgewandte Oberfläche der ersten Platte 52 aufgerauht und somit der Emissionskoeffizient angehoben wird. Bei Graphit besteht diese Möglichkeit zur Anhebung des Emissionskoeffizienten durch Aufrauhen im Gegensatz zu der hier verwendeten Glaskohle nicht.

Eine zweite Funktion der ersten Platte 52 besteht darin, die Bildung von Hohlräumen im SiC-Keimkristall 11 zu verhindern. Diese Hohlräume würden anschließend durch den Keimkristall 11 in den Einkristall 10 hineinwachsen. Aufgrund der niedrigen Reaktionsneigung von Glaskohle mit dem festen SiC des SiC-Keimkristalls 11 wird die Entstehung derartiger Hohlräume von Anfang an unterbunden.

Die dem SiC-Keimkristall 11 zugewandte Oberfläche der ersten Platte 52 ist zusätzlich poliert. Dadurch werden Hohlräume an der Grenzschicht zwischen dem SiC-Keimkristall 11 und der ersten Platte 52 vermieden, die sich ansonsten schon vor dem Beginn des eigentlichen Züchtungsprozesses nur aufgrund einer zu großen Oberflächenrauhigkeit ausbilden könnten.

Die zweite Platte 53 dient zur thermischen Isolation des Vorratsbereichs 30. An dieser Stelle ist es erwünscht, die Wärmeenergie möglichst im Vorratsbereich 30 zu halten, um die Sublimation von SiC in Gang zu halten. Die zweite Platte 53 aus Glaskohle trägt hierzu insofern bei, als ein in den Außenraum gerichteter dritter Wärmefluß 63 an der zweiten Platte 53 in den Vorratsbereich zurückgeleitet wird.

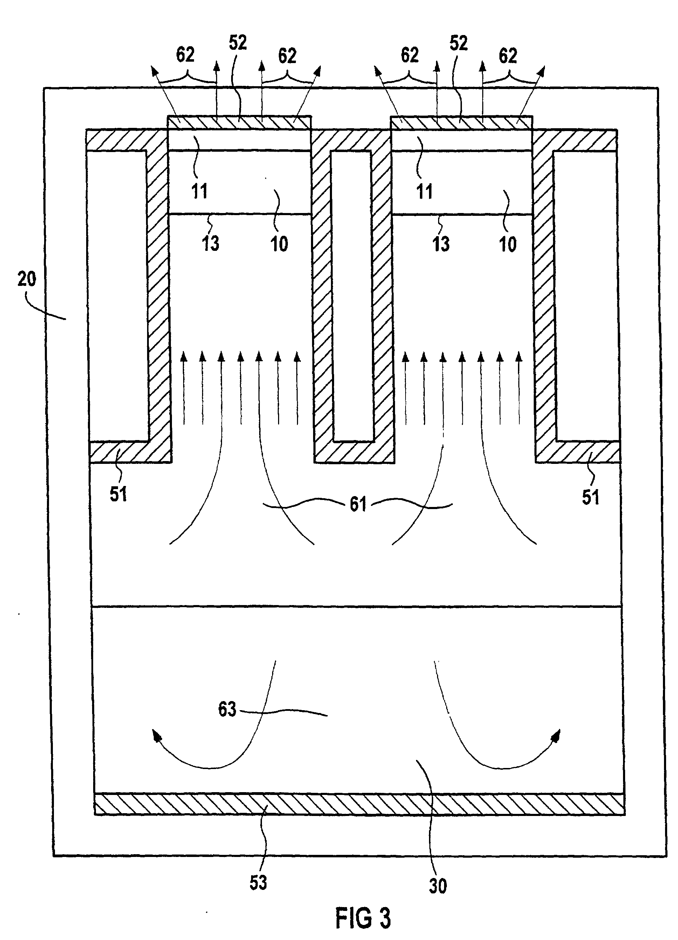

In Figur 3 wird ein Tiegel 20 gezeigt, der für die Herstellung von zwei SiC-Einkristallen 10 bestimmt ist. Auch dieser Tiegel 20 enthält in seinem Inneren mehrere Einsätze aus Glaskohle, die denen im Zusammenhang mit Figur 2 besprochenen entsprechen. Das Ausführungsbeispiel von Figur 3 enthält zwei getrennte Gaskanäle 51 sowie zwei SiC-Keimkristalle 11, auf die jeweils ein SiC-Einkristall 10 aufwächst. In einer nicht dargestellten Ausführungsform sind anstelle des einen Vorratsbereichs 30 zwei separate Vorratsbereiche vorgesehen.

Bevorzugte Modifikationen des hergestellten SiC-Einkristalls 10 sind 4H-, 6H- und 15R-SiC. Vorzugsweise besteht auch der SiC-Keimkristall 11 aus einem dieser SiC-Polytypen.

Als Material für den Tiegel 20 kommen alle entsprechend hitzebeständigen Stoffe in Frage; insbesondere geeignet ist hochreiner Elektrographit.

## Patentansprüche

1. Vorrichtung zur Herstellung mindestens eines Silicumcarbid(SiC)-Einkristalls (10) umfassend
a) einen Tiegel (20) mit
a1) mindestens einem Vorratsbereich (30) zur Aufnahme eines Vorrats (31) aus festem SiC,
a2) mindestens einem Kristallbereich (12) zur Aufnahme jeweils eines SiC-Keimkristalls (11), auf dem der SiC-Einkristall (10) aufwächst,
b) eine außerhalb des Tiegels (20) angeordnete Heizeinrichtung (40),
**dadurch gekennzeichnet, daß**
c) in dem Tiegel (20) mindestens ein Einsatz (51, 52, 53) aus Glaskohle angeordnet ist.

2. Vorrichtung nach Anspruch 1, **dadurch gekennzeichnet, daß** der Kristallbereich (12) an eine von dem Vorratsbereich (30) beabstandete Tiegelwand, insbesondere eine dem Vorratsbereich gegenüberliegende erste Tiegelwand (21), angrenzt.

3. Vorrichtung nach Anspruch 1 oder 2, **dadurch gekennzeichnet, daß** der Tiegel (20) zumindest weitgehend aus Graphit besteht.

4. Vorrichtung nach einem der Ansprüche 1 bis 3, **dadurch gekennzeichnet, daß** zwischen dem Vorratsbereich (30) und der ersten Tiegelwand (21), an die der Kristallbereich (12) angrenzt, ein Einsatz aus Glaskohle, insbesondere in Form eines hohlzylindrischen Gaskanals (51), angeordnet ist.

5. Vorrichtung nach Anspruch 4, **dadurch gekennzeichnet, daß** eine erste, dem herzustellenden SiC-Einkristall (10) zugeordnete Mittenachse (100) und eine zweite, dem Gaskanal (51) zugeordnete Mittenachse (200) nahezu parallel zueinander gerichtet sind.

6. Vorrichtung nach Anspruch 4 oder 5, **dadurch gekennzeichnet, daß** eine längs einer zweiten Mittenachse (200) verlaufende Wand (510) des Gaskanals (51) eine variierende Wanddicke aus Glaskohle aufweist.

7. Vorrichtung nach einem der Ansprücha 4 bis 6, **dadurch gekennzeichnet, daß** eine Wand (510) des Gaskanals (51) zwischen 0,1 mm und 5 mm dick ist.

8. Vorrichtung nach einem der Ansprüche 2 bis 7, **dadurch gekennzeichnet , daß** zwischen dem SiC-Keimkristall (11) und der ersten Tiegelwand (21) eine erste Platte (52) aus Glaskohle angeordnet ist.

9. Vorrichtung nach Anspruch 8, **dadurch gekennzeichnet, daß** die erste Platte (52) zwischen 0,1 mm und 2 mm, insbesondere 0,5 mm, dick ist.

10. Vorrichtung nach Anspruch 8 oder 9, **dadurch gekennzeichnet, daß** eine dem SiC-Keimkristall (11) zugewandte Oberfläche der ersten Platte (52) poliert ist.

11. Vorrichtung nach einem der Ansprüche 1 bis 10, **dadurch gekennzeichnet, daß** in dem Vorratsbereich (30) auf einer zweiten Tiegelwand (22), die den Vorratsbereich (30) nach unten begrenzt, eine zweite Platte (53) aus Glaskohle angeordnet ist.

12. Vorrichtung nach Anspruch 11, **dadurch gekennzeichnet, daß** die zweite Platte (53) zwischen 0,1 mm und 5 mm, insbesondere zwischen 2 mm und 5 mm, dick ist.

13. Verfahren zur Herstellung mindestens eines Silicumcarbid (SiC)-Einkristalls (10), bei dem
a) ein Vorrat (31) aus festem SiC in mindestens einen Vorratsbereich (30) eines Tiegels (20) eingebracht wird,
b) mindestens ein SiC-Keimkristall (11) in den Tiegel (20) eingebracht wird,
c) durch eine Erhitzung des Vorrats (30) das feste SiC sublimiert und SiC in der Gasphase erzeugt wird,
d) das SiC in der Gasphase zu dem mindestens einen SiC-Keimkristall (11) transportiert wird und dort als der mindestens eine SiC-Einkristall (10) aufwächst,
**dadurch gekennzeichnet, daß**
e) mindestens ein Wärmefluß (61, 62, 63) über mindestens einen in dem Tiegel (20) vorgesehenen Einsatz (51, 52, 53) aus Glaskohle gesteuert wird.

14. Verfahren nach Anspruch 13, **dadurch gekennzeichnet, daß** der SiC-Keimkristall an einer von dem Vorratsbereich beabstandeten Wand des Tiegels (20), insbesondere einer dem Vorratsbereich (30) gegenüberliegenden ersten Tiegelwand (21), angebracht wird.

15. Verfahren nach Anspruch 13 oder 14, **dadurch gekennzeichnet, daß** ein erster Wärmefluß (61), der den Transport des SiC's in der Gasphase zu dem SiC-Keimkristall (11) bewirkt, so gesteuert wird, daß sich eine Isotherm-Ebene und eine Ebene gleicher Konzentration des SiC's in der Gasphase zumindest an einer Kristallisationsfront (13) des SiC-Keimkristalls (11) oder des bereits aufgewachsenen SiC-Einkristalls (10) ausbilden.

16. Verfahren nach einem der Ansprüche 13 bis 15, **dadurch gekennzeichnet, daß** ein erster Wärmefluß (61), der den Transport des SiC's in der Gasphase zu dem SiC-Keimkristall (11) bewirkt, durch einen Einsatz aus Glaskohle in Form eines hohlzylindrischen Gaskanals (51) gesteuert wird.

17. Verfahren nach Anspruch 15 oder 16, **dadurch gekennzeichnet, daß** der erste Wärmefluß (61) mit einer Hauptrichtung, die nahezu parallel zu einer ersten, dem herzustellenden SiC-Einkristall (10) zugeordneten Mittenachse gerichtet ist, eingestellt wird.

18. Verfahren nach einem der Ansprüche 13 bis 17, **dadurch gekennzeichnet, daß** ein zweiter Wärmefluß (62), der zu einer Wärmeabfuhr am SiC-Keimkristall (11) führt, durch eine erste Platte (52) aus Glaskohle zwischen dem SiC-Keimkristall (11) und der ersten Tiegelwand (21) gesteuert wird.

19. Verfahren nach einem der Ansprüche 13 bis 18, **dadurch gekennzeichnet, daß** ein dritter Wärmefluß (63), der zu einer thermischen Isolation des Vorrats (31) führt, durch eine zweite Platte (53) aus Glaskohle zwischen dem Vorrat (31) und einer zweiten Tiegelwand (22) gesteuert wird.

## Claims

1. Device for producing at least one silicon carbide (SiC) single crystal (10), comprising
a) a crucible (20) having
a1) at least one storage region (30) for holding a stock (31) of solid SiC,
a2) at least one crystal region (12) for holding in each case one SiC seed crystal (11), on which the SiC single crystal (10) grows,
b) a heater device (40) arranged outside the crucible (20),
**characterized in that**
c) at least one insert (51, 52, 53) made from glassy carbon is arranged in the crucible (20).

2. Device according to Claim 1, **characterized in that** the crystal region (12) adjoins a crucible wall which is spaced apart from the storage region (30), in particular a first crucible wall (21) which lies opposite the storage region.

3. Device according to Claim 1 or 2, **characterized in that** the crucible (20) at least substantially comprises graphite.

4. Device according to one of Claims 1 to 3, **characterized in that** an insert made from glassy carbon, in particular in the form of a hollow cylindrical gas duct (51), is arranged between the storage region (30) and the first crucible wall (21) which is adjoined by the crystal region (12).

5. Device according to Claim 4, **characterized in that** a first centre axis (100), which is associated with the SiC single crystal (10) to be produced, and a second centre axis (200), which is associated with the gas duct (51), are oriented virtually parallel to one another.

6. Device according to Claim 4 or 5, **characterized in that** a wall (510) of the gas duct (51) running along a second centre axis (200) has a varying wall thickness of glassy carbon.

7. Device according to one of Claims 4 to 6, **characterized in that** a wall (510) of the gas duct (51) is between 0.1 mm and 5 mm thick.

8. Device according to one of Claims 2 to 7, **characterized in that** a first plate (52) made from glassy carbon is arranged between the SiC seed crystal (11) and the first crucible wall (21).

9. Device according to Claim 8, **characterized in that** the first plate (52) is between 0.1 mm and 2 mm, in particular 0.5 mm, thick.

10. Device according to Claim 8 or 9, **characterized in that** a surface of the first plate (52) which faces towards the SiC seed crystal (11) is polished.

11. Device according to one of Claims 1 to 10, **characterized in that** a second plate (53) of glassy carbon is arranged in the storage region (30) on a second crucible wall (22), which delimits the storage region (30) at the bottom.

12. Device according to Claim 11, **characterized in that** the second plate (53) is between 0.1 mm and 5 mm, in particular between 2 mm and 5 mm, thick.

13. Method for producing at least one silicon carbide (SiC) single crystal (10), in which
a) a stock (31) of solid SiC is introduced into at least one storage region (30) of a crucible (20),
b) at least one SiC seed crystal (11) is introduced into the crucible (20),
c) the solid SiC is sublimed as a result of the stock (30) being heated and SiC in the gas phase is generated,
d) the SiC in the gas phase is conveyed to the at least one SiC seed crystal (11), on which it grows as the as least one SiC single crystal (10),
**characterized in that**
e) at least one heat flux (61, 62, 63) is controlled by means of at least one insert (51, 52, 53) made from glassy carbon which is provided in the crucible (20).

14. Method according to Claim 13, **characterized in that** the SiC seed crystal is arranged on a wall of the crucible (20) which is spaced apart from the storage region, in particular a first crucible wall (21) which lies opposite the storage region (30).

15. Method according to Claim 13 or 14, **characterized in that** a first heat flux (61), which conveys the SiC in the gas phase to the SiC seed crystal (11), is controlled in such a way that an isothermal plane and a plane of uniform concentration of the SiC in the gas phase are formed at least at a crystallization front (13) of the SiC seed crystal (11) or of the SiC single crystal (10) which has already grown on.

16. Method according to one of Claims 13 to 15, **characterized in that** a first heat flux (61), which conveys the SiC in the gas phase to the SiC seed crystal (11), is controlled by means of an insert made from glassy carbon in the form of a hollow cylindrical gas duct (51).

17. Method according to Claim 15 or 16, **characterized in that** the first heat flux (61) is set with a principal direction which is oriented virtually parallel to a first centre axis associated with the SiC single crystal (10) to be produced.

18. Method according to one of Claims 13 to 17, **characterized in that** a second heat flux (62), which leads to dissipation of heat at the SiC seed crystal (11), is controlled by a first plate (52) of glassy carbon between the SiC seed crystal (11) and the first crucible wall (21).

19. Method according to one of Claims 13 to 18, **characterized in that** a third heat flux (63), which leads to thermal insulation of the stock (31), is controlled by a second plate (53) of glassy carbon between the stock (31) and a second crucible wall (22).

## Revendications

1. Dispositif de production d'au moins un monocristal (10) de carbure de silicium (SiC) comprenant
a) un creuset (20) ayant
a1) au moins une partie (30) de réserve destinée à recevoir une réserve (31) de SiC solide,
a2) au moins une partie (12) de cristal destinée à recevoir respectivement un cristal (11) germe de SiC, sur lequel croît le monocristal (10) de SiC,
b) un dispositif (40) de chauffage disposé à l'extérieur du creuset (20),
**caractérisé en ce que**
c) il est disposé dans le creuset (20) au moins une pièce rapportée (51, 52, 53) en carbone vitreux.

2. Dispositif suivant la revendication 1, **caractérisé en ce que** la partie (12) de cristal est adjacente à une paroi du creuset qui est à distance de la partie (30) de réserve, notamment à une première paroi (21) du creuset qui est opposée à la partie de réserve.

3. Dispositif suivant la revendication 1 ou 2, **caractérisé en ce que** le creuset (20) est au moins dans une grande mesure en graphite.

4. Dispositif suivant l'une des revendications 1 à 3, **caractérisé en ce qu'**il est disposé entre la partie (30) de réserve et la première paroi (21) de creuset, à laquelle la partie (12) de cristal est adjacente, une pièce rapportée en carbone vitreux, notamment sous la forme d'un canal (51) cylindrique tubulaire pour du gaz.

5. Dispositif suivant la revendication 4, **caractérisé en ce qu'**un premier axe (100) médian associé au monocristal (10) de SiC à produire et un deuxième axe (200) médian associé au canal (51) pour du gaz sont à peu près parallèles entre eux.

6. Dispositif suivant la revendication 4 ou 5, **caractérisé en ce qu'**une paroi (510) du canal (51) pour du gaz, qui s'étend le long d'un deuxième axe (200) médian, a une épaisseur de paroi en carbone vitreux qui varie.

7. Dispositif suivant l'une des revendications 4 à 6, **caractérisé en ce qu'**une paroi (510) du canal (51) pour du gaz a une épaisseur comprise entre 0,1 mm et 5 mm.

8. Dispositif suivant l'une des revendications 2 à 7, **caractérisé en ce qu'**il est interposé entre le cristal (11) germe de SiC et la première paroi (21) de creuset une première plaque (52) en carbone vitreux.

9. Dispositif suivant la revendication 8, **caractérisé en ce que** la première plaque (52) a une épaisseur comprise entre 0,1 mm et 2 mm et notamment a une épaisseur de 0,5 mm.

10. Dispositif suivant la revendication 8 ou 9, **caractérisé en ce qu'**une surface de la première plaque (52), qui est tournée vers le cristal (11) germe de SiC, est polie.

11. Dispositif suivant l'une des revendications 1 à 10, **caractérisé en ce qu'**il est disposé dans la partie (30) de réserve sur une deuxième paroi (22) de creuset, qui délimite vers le bas la partie (30) de réserve une deuxième plaque (53) en carbone vitreux.

12. Dispositif suivant la revendication 11, **caractérisé en ce que** la deuxième plaque (53) a une épaisseur comprise entre 0,1 mm et 5 mm et notamment une épaisseur comprise entre 2 mm et 5 mm.

13. Procédé de production d'au moins un monocristal (10) de carbure de silicium (SiC), dans lequel
a) on introduit une réserve (31) de SiC solide dans au moins une partie (30) de réserve d'un creuset (20),
b) on introduit au moins un cristal (11) germe de SiC dans le creuset (20),
c) en chauffant la réserve (30) on sublime le SiC solide et on produit du SiC en phase gazeuse,
d) on transporte le SiC de la phase gazeuse vers le au moins un cristal (11) germe de SiC et on l'y fait croître sous la forme du au moins un monocristal (10) de SiC,
**caractérisé en ce que**
e) on se rend maître d'au moins un flux (61, 62, 63) de chaleur par au moins une pièce rapportée (51, 52, 53) en carbone vitreux prévue dans le creuset (20).

14. Procédé suivant la revendication 13, **caractérisé en ce que** l'on met le cristal germe de SiC sur une paroi du creuset (20) qui est à distance de la partie de réserve, notamment sur une première paroi (21) du creuset qui est opposée à la partie (30) de réserve.

15. Procédé suivant la revendication 13 ou 14, **caractérisé en ce que** l'on se rend maître d'un premier flux (61) de chaleur qui provoque le transport du SiC en phase gazeuse au cristal (11) germe de SiC en constituant un plan isotherme et un plan d'équiconcentration du SiC en phase gazeuse au moins sur un front (13) de cristallisation du cristal (11) germe de SiC ou du monocristal (10) de SiC que l'on a déjà fait croître.

16. Procédé suivant l'une des revendications 13 à 15, **caractérisé en ce que** l'on se rend maître d'un premier flux (61) de chaleur, qui provoque le transport du SiC en phase gazeuse vers le cristal (11) germe de SiC par une pièce rapportée en carbone vitreux ayant la forme d'un canal (51) cylindrique tubulaire pour du gaz.

17. Procédé suivant la revendication 15 ou 16, **caractérisé en ce que** l'on règle le premier flux (61) de chaleur ayant une direction principale qui est dirigée à peu près parallèlement à un premier axe médian associé au monocristal (10) de SiC à produire.

18. Procédé suivant l'une des revendications 13 à 17, **caractérisé en ce que** l'on se rend maître d'un deuxième flux (62) de chaleur, qui donne une évacuation de la chaleur du cristal (11) germe de SiC par une première plaque (52) en carbone vitreux interposée entre le cristal (11) germe de SiC et la première paroi (21) du creuset.

19. Procédé suivant l'une des revendications 13 à 18, **caractérisé en ce que** l'on se rend maître d'un troisième flux (63) de chaleur qui donne une isolation thermique de la réserve (31) par une deuxième plaque (53) en carbone vitreux interposée entre la réserve (31) et une deuxième paroi (22) de creuset.
